# EUROPEAN PATENT SPECIFICATION

(11) **EP 2 882 004 B1**
(45) Date of publication and mention of the grant of the patent: **05.04.2017**
(21) Application number: 13196118.7
(22) Date of filing: 06.12.2013
(51) Int. Cl.: H01L 43/08, G11C 11/16

(54) **Memory device based on anisotropic magentoresistance**
Speichervorrichtung basierend auf anisotropem Magnetowiderstand
Dispositif de mémoire basé sur magnétorésistance anisotropique

(43) Date of publication of application: 10.06.2015
(73) Proprietor: Hitachi, Ltd., Tokyo (JP)
(72) Inventor: Wunderlich, Joerg, Cambridge, Cambridgeshire CB3 0HE (GB); Marti, Xavier, 162 53 Praha 6 (CZ); Jungwirth, Tomas, 162 53 Praha 6 (CZ)
(74) Representative: Piotrowicz, Pawel Jan Andrzej

(56) References cited:
- EP-A1- 2 065 886
- JP-A- 2007 048 388
- PETTI D ET AL: "Storing magnetic information in IrMn/MgO/Ta tunnel junctions via field-cooling", APPLIED PHYSICS LETTERS, AMERICAN INSTITUTE OF PHYSICS, US, vol. 102, no. 19, 13 May 2013 (2013-05-13) , pages 192404-192404, XP012172966, ISSN: 0003-6951, DOI: 10.1063/1.4804429 [retrieved on 2013-05-14]

## Description

The present invention relates to a non-volatile memory device. In particular, the present invention relates to an antiferromagnetic memory device.

Magnetoresistive random-access memory (MRAM) is becoming increasingly used as solid-state non-volatile memory.

A typical MRAM cell includes two ferromagnetic layers separated by a thin, non-magnetic insulating layer which provides a tunnel barrier. One ferromagnetic layer, usually referred to as a "pinned layer" or "reference layer", has a magnetization whose orientation is fixed. The other ferromagnetic layer, generally referred to as the "free layer", has a magnetization whose orientation can be switched so as to be parallel or anti-parallel to the orientation of the magnetization in the pinned layer. Switching can be achieved by applying an external magnetic field or by passing a current having a sufficiently high current density in a process known as "spin torque transfer" (STT) switching. The parallel and anti-parallel states have high and low resistances respectively and, thus, can be used to store a bit of information. An overview of spin electronics, including MRAM, can be found in C. Chappert, A. Fert, and F. N. Van Dau: "The emergence of spin electronics in data storage" Nature Materials, volume 6, pages 813 to 823 (2007).

Another form of magnetoresistive device is a tunnelling anisotropy magnetoresistance (TAMR) device, as described in C. Gould et al.: "Tunneling Anisotropic Magnetoresistance: A Spin-Valve-Like Tunnel Magnetoresistance Using a Single Magnetic Layer", Physical Review Letters, volume 93, page 117203 (2004). In a TAMR device, one of the ferromagnetic layers is replaced with a non-magnetic conductive layer. Magnetoresistance arises as a result of an anisotropy in local density of states at the interface between the tunnel barrier and the ferromagnetic layer.

As described in EP 2 065 886 A1, TAMR can be increased by including a thin layer of platinum or other transition metal between the non-magnetic insulating layer and the ferromagnetic layer.

B. G. Park et al.: "A spin-valve-like magnetoresistance of an antiferromagnet-based tunnel junction", Nature Materials, volume 10, pages 347 to 351 (2011) describes another TAMR-like device having a multi-layer stack formed by a layer of nickel-iron (NiFe), a layer of iridium manganese (IrMn), a layer of magnesium oxide (MgO) and a layer of platinum (Pt). The MgO layer provides a tunnel barrier between antiferromagnetic IrMn and non-magnetic Pt. Ferromagnetic moments in the NiFe layer are reversed by an external magnetic field and the exchange-spring effect of NiFe on the IrMn layer induces rotation of the antiferromagnetic moments in IrMn layer.

The ferromagnetic NiFe layer is exchange-coupled to the antiferromagnetic IrMn layer to form an exchange spring. The ferromagnetic NiFe layer allows weak magnetic fields (i.e. of the order of the magnetic anisotropy fields in typical magnets) to rotate the antiferromagnetic moments. However, this arrangement limits the thickness of the IrMn layer to dimensions not exceeding the domain wall width in the antiferromagnet. Since the exchange spring triggers rotation of the antiferromagnetic moments at the opposite interface to the antiferromagnet /tunnel barrier interface, an antiferromagnetic TAMR effect is observable in antiferromagnetic films which are thinner than the domain wall width in the antiferromagnet.

Recent experiments have demonstrated that room-temperature antiferromagnetic TAMR can be realized in the exchange spring tunnel junctions in a narrow window of antiferromagnetic layer thicknesses. In such tunnel junctions, the antiferromagnetic layer should be thin enough to allow for the exchange spring rotation of antiferromagnetic moments across the entire width of the antiferromagnet, while being thick enough to avoid the suppression of the Néel temperature, T_{N}, below room temperature due to size effects.

D. Petti et al., "Storing magnetic information in Ir/Mn/MgO/Ta tunnel junctions via field-cooling", Applied Physics Letters, vol. 102, 192404, (2013) describes Ta/MgO/IrMn tunnelling junctions containing no ferromagnetic elements, in which distinct metastable resistance states can be set by field cooling the devices from above the Néel temperature along different orientations.

According to a first aspect of the present invention there is provided a memory device as defined by claim 1. The antiferromagnet is not coupled to any ferromagnet.

Thus, a ferromagnet can be omitted from the memory device and stray magnetic fields produced by the memory device can be minimised and may even be eliminated. Moreover, the antiferromagnet can store information more robustly such that it has greater resilience to magnetic field perturbation.

The antiferromagnet may comprise an alloy which includes and/or a multilayer which includes a layer of a transition metal. The transition metal may be chromium (Cr), manganese (Mn), iron (Fe), cobalt (Co), nickel (Ni), copper (Cu), ruthenium (Ru), rhodium (Rh), palladium (Pd), gold (Ag), iridium (Ir), platinum (Pt) or silver (Au).

The antiferromagnet may comprise an alloy which includes a group 14 element, such as tin (Sn). The alloy may comprise up to 5% or up to 10% of the group 14 element. This can help to increase a transition temperature of the antiferromagnet.

The antiferromagnet may comprise an alloy which includes and/or a multilayer which includes a layer of a post-transition metal. The post-transition metal may be bismuth (Bi). The alloy may include manganese (Mn). For example, the alloy may comprise bismuth manganese (BiMn).

The antiferromagnet may comprise a semiconductor and/or a multilayer which includes a layer of a semiconductor. The semiconductor may be a ternary alloy comprising a group 1 or group 11 element, a group 7 element and a group 15 element. The ternary alloy may be lithium manganese arsenide (LiMnAs), copper manganese arsenide (CuMnAs), copper manganese phosphide (CuMnP) or barium manganese arsenide (BaMn₂As₂).

The antiferromagnet may comprise a semimetal and/or a multilayer which includes a layer of a semimetal.

The antiferromagnet may take the form of layer, for example, a patterned layer. The antiferromagnet may have a thickness of at least 1 nm, at least 2 nm, at least 5 nm, at least 10 nm or more. The antiferromagnet may have a thickness no more than 10 nm, no more than 20 nm, no more than 50 nm, no more than 100 nm or more.

The antiferromagnet may have an upper surface and the first and second contacts may be spaced apart and disposed on the upper surface.

The memory device may comprise a non-ferromagnetic support and the antiferromagnet may be formed directly on the non-ferromagnetic support.

The non-ferromagnetic support may comprise at least one seed layer for providing an atomically-smooth surface directly supporting the antiferromagnet. The at least one seed layer may include a multi-layer stack comprising two or more layers of tantalum (Ta) and at least one layer of ruthenium (Ru) each ruthenium layer interposed between two tantalum layers.

The memory device may further comprise a substrate supporting the antiferromagnet. The memory device may comprise a multilayer stack upstanding from the substrate.

The memory device may comprise third and fourth additional electrodes to the antiferromagnet for measuring four-terminal ohmic resistance of the antiferromagnet.

The, or each, electrode are non-ferromagnetic. The, or each electrode, may comprise a normal metal or a normal semiconductor. The electrode may comprise a transition metal, such as tantalum (Ta) or platinum (Pt).

The memory device may further comprise a non-ferromagnetic layer interposed between the antiferromagnet and the insulator. The non-ferromagnetic layer may comprise a transition metal, such as platinum (Pt) or palladium (Pd). The non-ferromagnetic layer may be thin, for example, one or two monolayers thick.

The first and second contacts are directly in contact with the antiferromagnet. The first and second electrodes may be disposed on a common surface (for example, an upper surface) of the antiferromagnet. The first and second electrodes may be embedded into (for example, diffused into) the antiferromagnet. The first and second electrodes may be disposed on side surfaces (on opposite sides) of the antiferromagnet.

There is preferably no tunnel barrier or at least no tunnel barrier which contributes significantly (e.g. more than 10%, more than 20% or more than 50%) to the device resistance between the first and second contacts. In other words, the memory device may use ohmic AMR readout and not TAMR readout.

The memory device may further comprise non-ferromagnetic layer(s) interposed between the first electrodes and the antiferromagnet and/or non-ferromagnetic layer(s) interposed between the first electrodes and the antiferromagnet. The layer(s) interposed between the first electrode and the antiferromagnet and the layer(s) interposed between the second electrode and the antiferromagnet may be the same.

According to a second aspect of the present invention there is provided apparatus comprising the non-volatile memory device according to claim 1, means for controlling temperature of the antiferromagnet and means for applying a magnetic field to the antiferromagnet.

The temperature controlling means may comprise a cryostat or refrigerator. The temperature controlling means may comprise a thermoelectric cooler. The temperature controlling means may include a heater, such as a resistor or laser. The memory device and the temperature controlling means may be supported on a single substrate, for example, in the form of integrally-formed temperature controller.

The magnetic field applying means may comprise a wire or coil. The memory device and the temperature controlling means may be supported on a (or the) single substrate.

According to a third aspect of the present invention there is provided memory comprising an array of memory cells, each memory cell including the non-volatile memory device according to claim 1, a temperature controller system and a set of magnetic field generators, each magnetic field generator configured to apply a magnetic field of first or second orientation to a respective memory device so as to configure the memory device in one of first and second metastable configurations.

The temperature controller system may comprise a thermoelectric cooler. The temperature controller system may include heater(s), such as resistor(s) or laser(s). The temperature controller system and the memory may be supported on a single substrate, i.e. an "on-chip" temperature controller system may be used.

Each magnetic field generator may comprise a set of one or more wires or coils. For example, a pair of wires (or coils) may be provided for each memory device. The magnetic field generators and memory cells may be supported on a single substrate, i.e. "on-chip" magnetic field generators may be used.

The temperature control elements, such as heaters, and magnetic field generators, e.g. conductive lines may be integrated into a unitary element. For example, a line having a weak link can be used not only to generate a magnetic field but also generate heat.

According to a fourth aspect of the present invention there is provided a method of configuring the non-volatile memory device according to claim 1, the method comprising heating the antiferromagnet to a first temperature which is sufficiently high to allow magnetic moments in the antiferromagnet to be re-oriented, applying an external magnetic field to the antiferromagnet having re-orientable magnetic moments and cooling or allowing cooling (for example, by stopping heating) of the antiferromagnet to a second temperature lower than the first temperature. The magnetic field can be applied while the antiferromagnet is being cooled or cooling or for part of the time that the antiferromagnet is being cooled or cooling. The magnetic field may be removed after the antiferromagnet is at the second temperature.

The first temperature may be at or above the Néel temperature of the antiferromagnet. Susceptibility tends to peak at the Néel temperature. However, the first temperature may be below the Néel temperature, provided that susceptibility is large enough for magnetic moments in the antiferromagnet to be re-orientated.

The second temperature is sufficiently low such that susceptibility is small enough to prevent magnetic moments in the antiferromagnet from being re-oriented.

The method may comprise applying a bias (e.g. a voltage bias or current bias) between the first and second contacts so as to determine an ohmic anisotropic magnetoresistance.

Certain embodiments of the present invention will now be described, by way of example, with reference to the accompanying drawings in which:
Figure 1 is a schematic diagram of a layer structure including an antiferromagnetic layer which is not coupled to any ferromagnetic layer;
Figure 2 schematically illustrates a device formed from the layer structure shown in

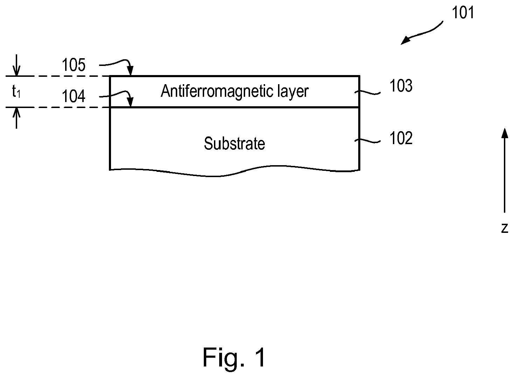

Figure 1 which includes an antiferromagnet which is not coupled to any ferromagnet;

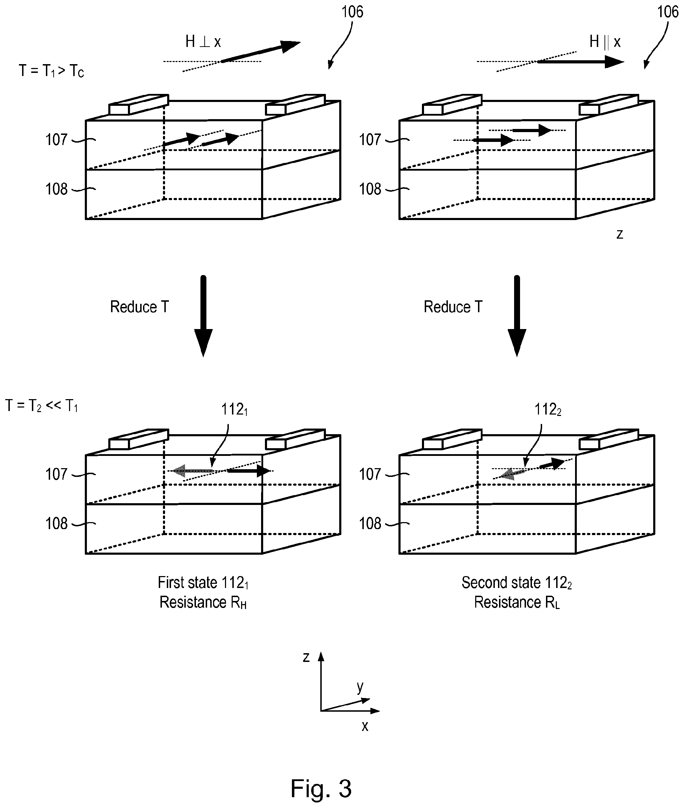

Figure 3 schematically illustrates first (high-resistance) and second (low-resistance) states;

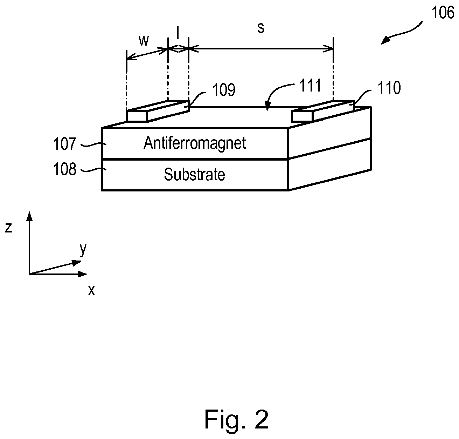

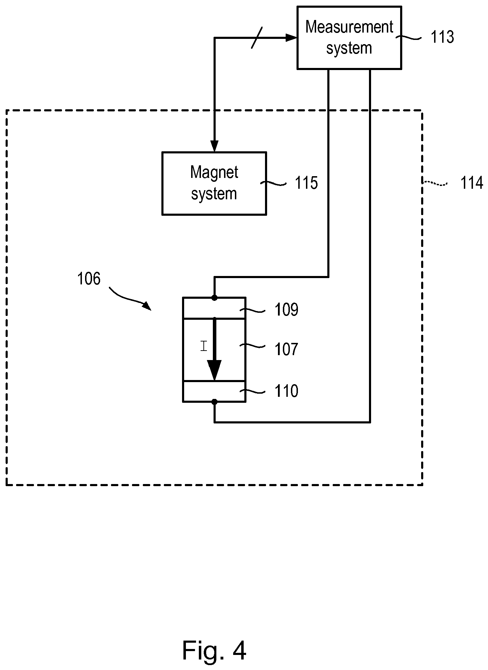

Figure 4 schematically illustrates apparatus for configuring and measuring the antiferromagnet shown in Figure 2;

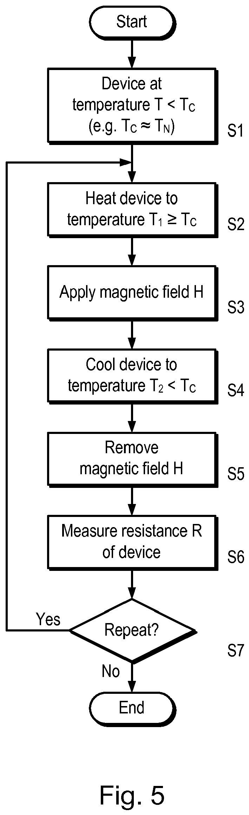

Figure 5 is a process flow diagram of a method of configuring and measuring the antiferromagnet shown in Figure 3;

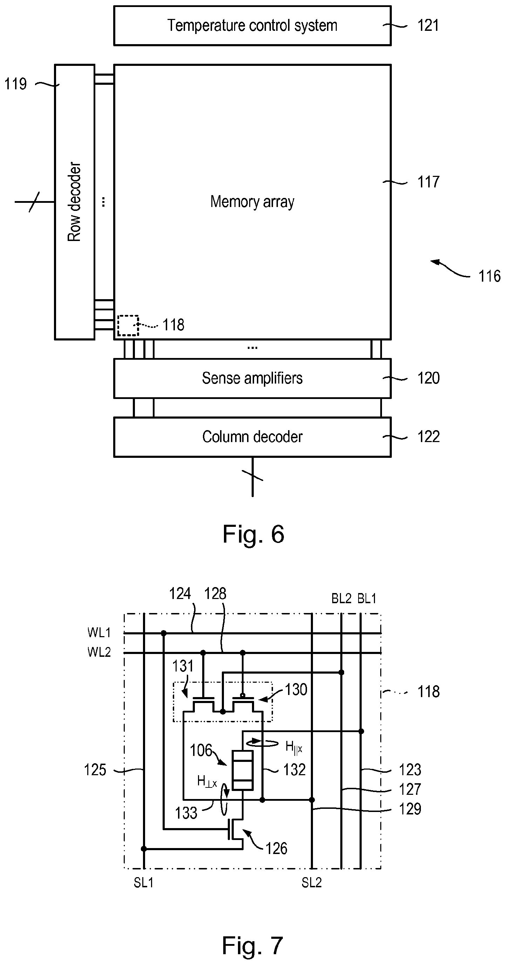

Figure 6 schematically illustrates a memory including an array of memory cells; and
Figure 7 schematically illustrates a memory cell.

Referring to Figure 1, a layer structure 101 is shown. The layer structure 101 comprises a substrate 102 and an antiferromagnetic layer 103 formed on an upper surface 104 of the substrate 102. The substrate 102 is electrically insulating. The substrate 102 can take the form of an oxidized silicon substrate, for example, 700 nm of silicon oxide (SiO₂) on (001) silicon.

The antiferromagnetic layer 103 is electrically conductive. The antiferromagnetic material in the antiferromagnetic layer 103 may be monocrystalline or polycrystalline. The antiferromagnetic material in the antiferromagnetic layer 103 may be a metal alloy or a semiconductor material. The antiferromagnetic layer 103 may be a layer of Ir_{0.2}Mn_{0.8}. The antiferromagnetic layer 103 has a thickness, t₁. The thickness, t₁, may have a value in a range from 2 to 8 nm, i.e. 2 ≤ t₁ ≤ 8 nm. The thickness, t₁, can be thicker than 8 nm, i.e. t₁ ≥ 8 nm. For example, the antiferromagnetic layer 5 can have a thickness of at least 10 nm, i.e. t₁ ≥ 10 nm, of at least 20 nm, i.e. t₁ ≥ 20 nm, at least 50 nm, i.e. t₁ ≥ 50 nm, or at least 100 nm, i.e. t₁ ≥ 100 nm.

The antiferromagnetic layer 103 is deposited under an ultrahigh vacuum by radiofrequency sputtering. A magnetic field of 5 mT may be applied in an in-plane direction of the substrate 102 during deposition. Other methods of deposition, such as evaporation, atomic layer deposition and the like, may be used. The antiferromagnetic layer 103 has an upper surface 105.

The layer structure 101 does not include a layer of ferromagnetic material, such as nickel iron (NiFe). Thus, the antiferromagnetic layer 103 is not coupled (via exchange coupling) to any ferromagnetic layer or region. Expressed differently, the antiferromagnetic layer 103 is ferromagnetically decoupled.

Referring also to Figure 2, an antiferromagnetic device 106 can be formed by patterning the layer structure 101.

The device 106 comprises an antiferromagnet 107 (which may be provided by the unpatterned antiferromagnetic layer 103) supported by a non-ferromagnetic substrate 108 (which may be provided by the unpatterned substrate 102) and first and second contacts 109, 110 (or "electrodes") in direct contact with the antiferromagnet 107. In this case, the contacts 109, 110 are made on an upper surface 111 of the antiferromagnet 107. There is no tunnel barrier, or at least no tunnel barrier which contributes significantly to the device resistance, between the first and second contacts 109, 110.

The contacts 109, 110 are formed from metallic, non-ferromagnetic material. For example, the contacts 109, 110 may be formed of gold (Au).

The contacts 109, 110 are spaced apart in a direction which defines a direction of current flow. The direction of current flow is labelled as the x-direction. If the antiferromagnetic material is monocrystalline, the x-direction may be aligned with a crystallographic direction.

The contacts 109, 110 have a separation, s. The separation, s, may be, for example, 1 µm. However, the separation, s, may be less than or more than 1 µm. The contacts 109, 110 have a length, 1, and width, w. The width, 1, may be larger or smaller than the separation, s. The contacts 109, 110 and the antiferromagnet 107 are arranged so as to have a well-defined direction of current flow which includes a straight path section. For example, this may be achieved by having an antiferromagnetic layer which has a thickness, t₁, which is less than the contact separation, s, and the contact width, w.

The antiferromagnet 107 can exhibit different metastable states corresponding to different spin configurations in the antiferromagnet 107.

At a temperature much lower than the Néel temperature, T_{N}, of the antiferromagnet 107, magnetic susceptibility χ of the antiferromagnet 107 is vanishingly small, i.e. zero. Thus, the antiferromagnet 107 is not polarized by the application of an external magnetic field. As temperature T increases and approaches the Néel temperature, magnetic susceptibility χ increases. As temperature T is increased, anisotropy energy of magnetic moments in the antiferromagnet 107 decreases. Thus, at a sufficiently high temperature (which may be above or below the Néel temperature, T_{N}), reorientation of magnetic moments in the antiferromagnet 107 becomes possible and an applied external magnetic field can induce a magnetization in the antiferromagnet 107. If the antiferromagnet 107 is cooled, then orientation of magnetic moments in the antiferromagnet 107 is frozen.

The state of the antiferromagnet 107 can be set by applying by applying an external magnetic field at the transition temperature so as to align magnetic moments in the layer of antiferromagnetic material and, while the magnetic field is still being applied, field-cooling the layer and, once at a sufficiently low temperature, removing the external magnetic field. The state can be detected electrically using antiferromagnetic ohmic anisotropic magnetoresistance (AFM AMR).

Using such a field-cooling approach, the need for an exchange spring can be avoided and so a ferromagnet need not be used. This allows thicker antiferromagnetic films to be used.

Referring also to Figure 3, starting at a temperature T₁ at or above a critical temperature T_{C} (which can be the Néel temperature T_{N}), a first, high resistance state R_{H} and a second, low resistance state R_{H} of the antiferromagnet 107 are obtained by cooling the device 106 in magnetic fields applied along the x- or y-directions. The enhanced susceptibility of the antiferromagnetic material when crossing the Néel temperature T_{N} allows realization of different metastable antiferromagnetic configurations 112₁, 112₂.

Referring to Figure 4, a Quantum Design (RTM) Physical Property Measurement System (PPMS) 113 and an Oxford Instruments cryostat 114 furnished with vector magnet 115 is used to perform the magneto-transport measurements.

Referring also to Figure 5, a device 106 is cooled or is at, for example, base temperature, T_{b}, of the cryostat (step S1). The device 106 is then warmed to temperature T₁ which is at or about the critical temperature Tc (step S₂). The critical temperature Tc is typically the Néel temperature T_{N} of the antiferromagnet 107. However, in some cases, realignment of spins can occur at a temperature T slightly below the Néel temperature T_{N}. A magnetic field H is applied in a given direction (step S₃) and, while the magnetic field is still applied, the device 106 is cooled back to a temperature T₂ below critical temperature Tc (step S6). The resistance of the device 106 can be measured using AMR using a voltage or current source (not shown) which results in current flow between the contacts 109, 110. Orientation of magnetic moments in the antiferromagnet 107 with respect current flow determines the resistance state.

Referring to Figure 6, a non-volatile memory 116 is shown. The memory 116 includes an array 117 of cells 118, a row decoder 119, sense amplifiers 120, a column decoder 121 and a temperature control system 122.

The temperature control system 122 can be configured to heat individual cells 118, several cells 118 and/or the whole array 117.

The temperature control system 121 can include resistors, laser or other heat-generating elements (not shown).

Self-heating arrangements can be used. For example, a conductive line used to generate a magnetic field can include a weak link (i.e. a resistive section) which heats up when a current is passed through the line. Thus, the conductive line can be used not only to generate a magnetic field, but also to heat the antiferromagnet. Additionally or alternatively, internal heat generation arising from Joule heating when a current is passed through an antiferromagnet can be used to heat the antiferromagnet.

The temperature control system 122 can include thermoelectric cooling devices (not shown).

Referring also to Figure 7, a memory cell 118 is shown. The memory cell 118 includes an antiferromagnet ohmic resistor.

The memory cell 118 can be selected and the state of the cell 118 can be read using a first bit line 123, a first word line 124 and first select line 125 using a transistor 126 whose channel is arranged in series between the antiferromagnetic 106 and the select line 125 and which is controlled by the first word line 124.

The state of the cell 118 can be set using a second bit line 127, a second word line 128 and second select line 129 using a pair of transistor 130, 131 having non-inverting and inverting gates. Current through the bit line 127 can thus be selectively routed via first and second magnetic field generating lines 132, 133 which are orientated perpendicularly with respect to each other. The first magnetic field generating line 132 is used to generate a magnetic field parallel to the current path between the contacts 109, 110. The second magnetic field generating line 133 is used to generate a magnetic field perpendicular to the current path between the contacts 109, 110.

It will be appreciated that many modifications may be made to the embodiments hereinbefore described.

The device can have different dimensions. For example, a thicker antiferromagnetic layer can be used. A top contact layer which is thicker or thinner can be used. The area of the antiferromagnetic layer can be different. Other materials, for example, other antiferromagnetic materials can be used. The antiferromagnetic layer may take the form of an alloy or a multilayer.

The ohmic antiferromagnetic configuration can be configured differently. For example, the antiferromagnet need not be planar. The antiferromagnet may be a vertical structure, for example a pillar, which is sufficiently narrow with respect to its height (i.e. having a sufficiently large aspect ratio) to define a current path.

Other different memory array arrangements and memory cell arrangements may be used.

The critical temperature, Tc, may exceed room temperature (i.e. about 293 K).

A cryostat or other cooling system may not be required.

T₂ may be room temperature. T₁ may be about 373 K or more.

## Claims

1. A non-volatile memory device comprising an antiferromagnet (107) and first and second contacts (109, 110) to the antiferromagnet for measuring ohmic resistance of the antiferromagnet **characterised in that** the antiferromagnet is not coupled to a ferromagnet and the first and second contacts are directly in contact with the antiferromagnet.

2. A non-volatile memory device according to claim 1, further comprising a non-ferromagnetic support, wherein the antiferromagnet (107) is formed directly on the non-ferromagnetic support.

3. A non-volatile memory device according to claim 2, wherein the non-ferromagnetic support comprises at least one seed layer providing an atomically-smooth surface directly supporting the antiferromagnet.

4. A non-volatile memory device according to any preceding claim, comprising third and fourth additional electrodes to the antiferromagnet for measuring four-terminal ohmic resistance of the antiferromagnet (107).

5. A non-volatile memory device according to any preceding claim, further comprising a substrate (108) supporting the antiferromagnet (107).

6. A non-volatile memory device according to any one of claims 1 to 5, further comprising non-ferromagnetic layer(s) interposed between the first and second electrodes and the antiferromagnet.

7. Apparatus comprising:
a non-volatile memory device according to any one of claims 1 to 6;
means (114) for controlling temperature of the antiferromagnet (107); and
means (115) for applying a magnetic field to the antiferromagnet.

8. Memory (116) comprising:
an array (117) of memory cells (118), each memory cell including a non-volatile memory device according to any one of claims 1 to 6;
a temperature controller system (121); and
a set of magnetic field generators (132, 133), each magnetic field generator configured to apply a magnetic field of first or second orientation to a respective non-volatile memory device so as to configure the memory device in one of first and second metastable configurations.

9. A method of configuring a non-volatile memory device according to one of claims 1 to 6, the method comprising:
heating the antiferromagnet (107) to a first temperature which is sufficiently high to allow re-orientation of magnetic moments in the antiferromagnet;
applying an external magnetic field to the antiferromagnet while magnetic moments are re-orientable; and
cooling or allowing cooling of the antiferromagnet to a second temperature lower than the first temperature.

10. A method according to claim 9, wherein the first temperature is at or above the Néel temperature (T_{N}) of the antiferromagnet (107).

11. A method according to claim 9 or 10, wherein the second temperature is sufficiently low such that susceptibility is small enough to prevent magnetic moments in the antiferromagnet from being re-oriented.

## Patentansprüche

1. Nichtflüchtiges Speichergerät, das einen Antiferromagneten (107) und einen ersten und zweiten Kontakt (109, 110) zu dem Antiferromagnet zum Messen des ohmschen Widerstands des Antiferromagnets umfasst, **dadurch gekennzeichnet, dass** der Antiferromagnet nicht mit einem Ferromagnet gekoppelt ist und der erste und zweite Kontakt in direktem Kontakt mit dem Antiferromagneten sind.

2. Nichtflüchtiges Speichergerät nach Anspruch 1, das ferner einen nicht ferromagnetischen Träger umfasst, wobei der Antiferromagnet (107) direkt auf dem nicht ferromagnetischen Träger ausgebildet ist.

3. Nichtflüchtiges Speichergerät nach Anspruch 2, wobei der nicht ferromagnetische Träger wenigstens eine Seed-Schicht umfasst, die eine atomisch glatte Oberfläche aufweist, die den Antiferromagneten direkt trägt.

4. Nichtflüchtiges Speichergerät nach einem vorherigen Anspruch, das eine dritte und ein vierte zusätzliche Elektrode zu dem Antiferromagnet zum Messen des ohmschen Vier-Anschluss-Widerstands des Antiferromagnets (107) umfasst.

5. Nichtflüchtiges Speichergerät nach einem vorherigen Anspruch, das ferner ein den Antiferromagneten (107) tragendes Substrat (108) umfasst.

6. Nichtflüchtiges Speichergerät nach einem der Ansprüche 1 bis 5, das ferner (eine) nicht ferromagnetische Schicht(en) umfasst, die zwischen der ersten und zweiten Elektrode und dem Antiferromagnet angeordnet ist/sind.

7. Vorrichtung, die Folgendes umfasst:
ein nichtflüchtiges Speichergerät nach einem der Ansprüche 1 bis 6;
Mittel (114) zum Regeln der Temperatur des Antiferromagnets (107); und
Mittel (115) zum Anlegen eines Magnetfelds an den Antiferromagneten.

8. Speicher (116), der Folgendes umfasst:
ein Array (117) von Speicherzellen (118), wobei jede Speicherzelle ein nichtflüchtiges Speichergerät nach einem der Ansprüche 1 bis 6 beinhaltet;
ein Temperaturregelsystem (121); und
einen Satz von Magnetfeldgeneratoren (132, 133), wobei jeder Magnetfeldgenerator zum Anlegen eines Magnetfelds mit einer ersten oder zweiten Orientierung an ein jeweiliges nichtflüchtiges Speichergerät konfiguriert ist, um das Speichergerät in einer ersten oder einer zweiten metastabilen Konfiguration zu konfigurieren.

9. Verfahren zum Konfigurieren eines nichtflüchtigen Speichergeräts nach einem der Ansprüche 1 bis 6, wobei das Verfahren Folgendes beinhaltet:
Erhitzen des Antiferromagnets (107) auf eine erste Temperatur, die hoch genug ist, um eine Umorientierung von magnetischen Momenten in dem Antiferromagnet zuzulassen;
Anlegen eines externen Magnetfelds an den Antiferromagneten, während magnetische Momente umorientierbar sind; und
Kühlen oder Kühlenlassen des Antiferromagnets auf eine zweite Temperatur, die niedriger ist als die erste Temperatur.

10. Verfahren nach Anspruch 9, wobei die erste Temperatur auf oder über der Néel-Temperatur (T_{N}) des Antiferromagnets (107) ist.

11. Verfahren nach Anspruch 9 oder 10, wobei die zweite Temperatur niedrig genug ist, so dass die Anfälligkeit gering genug ist, um eine Umorientierung von magnetischen Momenten in dem Antiferromagnet zu verhindern.

## Revendications

1. Dispositif de mémoire non volatile comprenant un élément antiferromagnétique (107) et des premier et deuxième contacts (109, 110) connectés à l'élément antiferromagnétique pour mesurer la résistance ohmique dudit élément antiferromagnétique, **caractérisé en ce que** l'élément antiferromagnétique n'est pas couplé à un élément ferromagnétique et **en ce que** les premier et deuxième contacts sont directement en contact avec l'élément antiferromagnétique.

2. Dispositif de mémoire non volatile selon la revendication 1, comprenant en outre un support non ferromagnétique, l'élément antiferromagnétique (107) étant formé directement sur ledit support non ferromagnétique.

3. Dispositif de mémoire non volatile selon la revendication 2, dans lequel le support non ferromagnétique comprend au moins une couche de germe fournissant une surface atomiquement lisse qui supporte directement l'élément antiferromagnétique.

4. Dispositif de mémoire non volatile selon l'une quelconque des revendications précédentes, comprenant des troisième et quatrième électrodes supplémentaires connectées à l'élément antiferromagnétique pour mesurer sur quatre bornes la résistance ohmique de l'élément antiferromagnétique (107).

5. Dispositif de mémoire non volatile selon l'une quelconque des revendications précédentes, comprenant en outre un substrat (108) qui supporte l'élément antiferromagnétique (107).

6. Dispositif de mémoire non volatile selon l'une quelconque des revendications 1 à 5, comprenant en outre une ou plusieurs couches non ferromagnétiques intercalées entre les première et deuxième électrodes et l'élément antiferromagnétique.

7. Appareil comprenant :
un dispositif de mémoire non volatile selon l'une quelconque des revendications 1 à 6 ;
des moyens (114) pour commander la température de l'élément antiferromagnétique (107) ; et
des moyens (115) pour appliquer un champ magnétique à l'élément antiferromagnétique.

8. Mémoire (116) comprenant :
un réseau (117) de cellules de mémoire (118), chaque cellule de mémoire comportant un dispositif de mémoire non volatile selon l'une quelconque des revendications 1 à 6 ;
un système de commande de température (121) ; et
un ensemble de générateurs de champ magnétique (132, 133), chaque générateur de champ magnétique étant configuré pour appliquer un champ magnétique ayant une première ou une deuxième orientation à un dispositif de mémoire non volatile respectif de façon à configurer le dispositif de mémoire dans une parmi une première et une deuxième configuration métastable.

9. Procédé de configuration d'un dispositif de mémoire non volatile selon l'une quelconque des revendications 1 à 6, ledit procédé comprenant les étapes consistant à :
chauffer l'élément antiferromagnétique (107) à une première température qui est suffisamment élevée pour permettre la réorientation des moments magnétiques dans l'élément antiferromagnétique ;
appliquer un champ magnétique externe à l'élément antiferromagnétique pendant que les moments magnétiques sont réorientables ; et
refroidir ou laisser refroidir l'élément antiferromagnétique à une deuxième température inférieure à la première température.

10. Procédé selon la revendication 9, dans lequel la première température est voisine de ou supérieure à la température de Néel (T_{N}) de l'élément antiferromagnétique (107).

11. Procédé selon la revendication 9 ou la revendication 10, dans lequel la deuxième température est suffisamment basse pour que la susceptibilité soit assez petite pour empêcher la réorientation des moments magnétiques dans l'élément antiferromagnétique.
